# EUROPEAN PATENT SPECIFICATION

(11) **EP 3 553 829 B1**
(45) Date of publication and mention of the grant of the patent: **08.06.2022**
(21) Application number: 18461549.0
(22) Date of filing: 13.04.2018
(51) Int. Cl.: H01L 31/0224

(54) **A SILICON PHOTOVOLTAIC CELL AND A METHOD FOR MANUFACTURING SILICON PHOTOVOLTAIC CELLS**
SILICIUMFOTOVOLTAIKZELLE UND VERFAHREN ZUR HERSTELLUNG VON SILICIUMFOTOVOLTAIKZELLEN
CELLULE PHOTOVOLTAÏQUE EN SILICIUM ET PROCÉDÉ DE FABRICATION DE CELLULES PHOTOVOLTAÏQUES EN SILICIUM

(43) Date of publication of application: 16.10.2019
(73) Proprietor: Centrum Badan i Rozwoju Technologii dla Przemyslu S.A., 00-120 Warszawa (PL); Hanplast Sp. z.o.o., 85-862 Bydgoszcz (PL); Instytut Fizyki Polskiej Akademii Nauk, 02-668 Warszawa (PL); Godlewski, Marek, 03-543 Warszawa (PL)
(72) Inventor: Putynkowski, Grzegorz, 00-193 Warszawa (PL); Sobkow, Jacek, 68-120 Ilowa (PL); Bartmanski, Marcin, 00-745 Warszawa (PL); Leszczynska, Karolina, 06-100 Pultusk (PL); Pietruszka, Rafal, 03-149 Warszawa (PL); Witkowski, Bartlomiej, 03-138 Warszawa (PL); Godlewski, Marek, 03-543 Warszawa (PL); Majchrowicz, Aleksander, 86-032 Niemcz (PL)
(74) Representative: Kancelaria Eupatent.pl Sp. z.o.o

(56) References cited:
- WO-A1-2016/182465
- US-A1- 2017 069 772
- PIETRUSZKA R ET AL: "ZnO/Si heterojunction solar cell fabricated by atomic layer deposition and hydrothermal methods", SOLAR ENERGY, vol. 155, 1 August 2017 (2017-08-01), pages 1282-1288, XP085233203, ISSN: 0038-092X, DOI: 10.1016/J.SOLENER.2017.07.071

## Description

The invention relates to a silicon photovoltaic cell and a method of manufacturing silicon photovoltaic cells, in particular hybrid cells with increased photoconversion efficiency.

Photovoltaic structures serve as electrical energy source - during illumination they generate electric voltage. Various types of photovoltaic structures are known, wherein the most commonly known are silicon structures, including monocrystalline, polycrystalline and amorphous structures.

A PCT patent application WO2015128825 discloses a photovoltaic cell structure, having a semiconductor p-type substrate, with a bottom electric contact, upon which an active ZnO film is present, with a transparent ZnO:AI electrode, characterized in that the active ZnO layer, located between the preferably silicon substrate and the transparent electrode layer, is a layer of ZnO nanorods which are at least 50 nm thick, deposited on nucleating layer. This solution is not foreseen for use in PERC or SWCT technology.

A Polish patent application PL412250 discloses a photovoltaic cell structure, comprising a semiconductor p-type substrate, with a bottom electric contact, upon which a layer containing ZnO and ZnMgO is present, and upon which a transparent conductive layer is present, preferably a ZnO:AI layer, with an electric contact, characterized in that the active layer is Si/ZnO/ZnMgO multijunction, wherein the layer of ZnO nanostructures is 10 to 2000 nm thick and deposited with a 1 to 2000 nm thick ZnMgO layer. This solution is not foreseen for use in PERC or SWCT technology.

The scientific publication PIETRUSZKA et al: "ZnO/Si heterojunction solar cell fabricated by atomic layer deposition and hydrothermal methods", SOLAR ENERGY, vol. 155, DOI: 10.1016/J- SO LEN ER.2017.07.071 describes a photovoltaic (PV) cell having a substrate layer on the form of Si wafer with a native SiO₂. The PV cell comprises the emitter layer of AZO Zn₁₋ₓMgₓO/ZnO_{NR}, on top of the the silicon wafer with a passivated emitter rear contact (PERC). The cell exhibits maximum ZnO/Si efficiency of 10 to 14%. The document suggests possible improvements in the emitter layer, however, it does not describe alternatives for the layer of native SiO₂.

One of the known technologies of manufacturing photovoltaic structures is SWCT (SmartWire Connection Technology), in which the active surface is increased during a low-temperature processes of connecting electrodes of the cell with a module, therefore increasing performance (including photoconversion efficiency) and durability of the component. This technology is based on substituting classic soldering of a charge accumulating stripe (busbar) to cells, with laminating a net of microwires with contact points of silicon cells. Use of such technology has a direct impact on power increase of the produced modules, as well as increase of their service life. Modules manufactured with the SWCT technology are not exposed to high temperature during the connecting process, as they are in traditional busbar technology. Preliminary connecting of microwires with the polymer foil is realized at the temperature of 90°C, after that a tape with microwires is deposited on prepared silicon cells and preliminary welded at the temperature of 140-180°C. In the final stage, the whole module is laminated at the temperature of ca. 140°C. The lower temperature during step of connecting of cells generates less thermal stresses in the connected silicon cells. The application of microwires with the diameter of 0,2 mm for 18 contact wires covers 1,7% of the surface of the cell, while in busbar technology the average coverage of the surface of the cell is equal to 2,9%. The measurable benefits from using the SWCT technology include a power increase of ca. 7% and increase in yield of ca. 3% in relation to the traditional busbar technology. Another advantage is 80% reduction of the amount of used silver, as the result of abandoning the soldering of charge accumulating stripes.

Cells adapted to the SWCT technology are offered as a PERC (Passivated Emitter and Rear Cell) type or an HJT (Heterojunction Technology) type.

It would be desirable to develop an alternative technology of manufacturing silicon cells with an optimized architecture, dedicated to a manufacturing line of photovoltaic modules in the SmartWire technology.

The solution according to the present invention provides a new structure for a silicon photovoltaic cell, which combines the features of the SmartWire collecting electrodes with the PERC and HJT cells having adhesion parameters of metallic contacts.

The object of the invention is a silicon photovoltaic cell, and a method of manufacturing silicon photovoltaic cells according to the appended claims.

The solution according to the present invention is characterized by increased parameters of the efficiency of conversion of solar energy to electricity (as compared to standard and PERC cells), can be manufactured in a low-cost and energy-efficient process integrated with a manufacturing plant used for other technologies, and also the manufactured cells are characterized by a high durability. The technology according to the invention provides repeatability of the cells energy efficiency parameters for various manufacturing scales, even variable scales. The technology allows to use the key modules of the manufacturing plant for various processes of manufacturing the cells, e.g. heterostructural and single-junction hybrid PERC cells and heterostructural and multi-junction double-sided cells.

The method presented herein is presented by means of example embodiment on a drawing, wherein:
Fig. 1 presents schematically an architecture of a standard PERC cell, known in the art;
Fig. 2 presents schematically an architecture of a cell according to the invention;
Fig. 3 presents a standard technology of manufacturing a PERC cell;
Fig. 4 presents the technology of manufacturing a cell according to the invention.

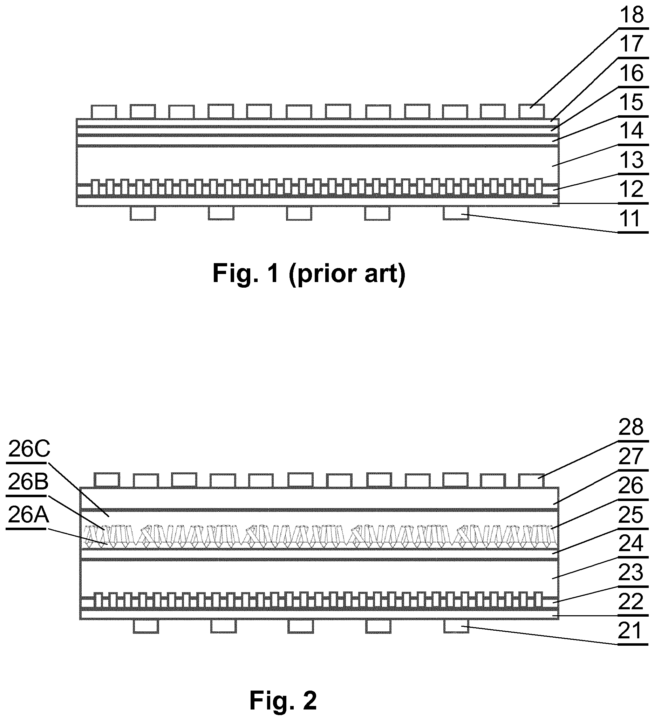

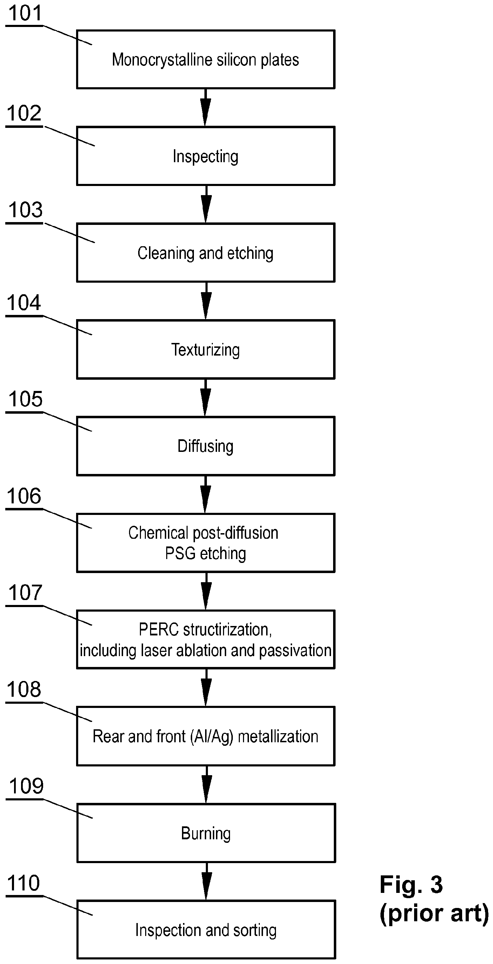

Fig. 1 presents an architecture of a standard PERC cell as known in the art, which is typically manufactured according to a standard technology as presented in Fig. 3.

The process starts with providing in step 101 a substrate 14 in the form of a monocrystalline silicon (Si) p-type plate, which is inspected in step 102 in order to examine whether it meets quality requirements. Then in step 103 the plate 14 is cleaned and etched. In step 104 texturization is carried out, which consists of chemical etching of the silicon substrate to obtain a desired surface texture. In step 105 phosphorus diffusion occurs and as a result, an n-type emitter 15 is obtained on the front side of the plate 14. Subsequently in step 106 etching is carried out in order to chemically remove the post-diffusion Phosphosilicate glass (PSG). In step 107 PERC structurization is carried out, including laser ablation and passivation, producing passivating layer of aluminum oxide (Al₂O₃) 13 on the back side of the substrate 14, as well as modifying the front part of the cell by making a UV layer and an antireflective layer. Subsequently in step 108, the rear metallization is carried out to make an aluminum layer (Al) 12, and a front metallization to make silver (Ag) upper metallic contacts (fingers), as well as silver (Ag) bottom metallic contacts 11 (pads). The obtained structure is then subjected to burning in step 109, and the finished products are inspected and sorted.

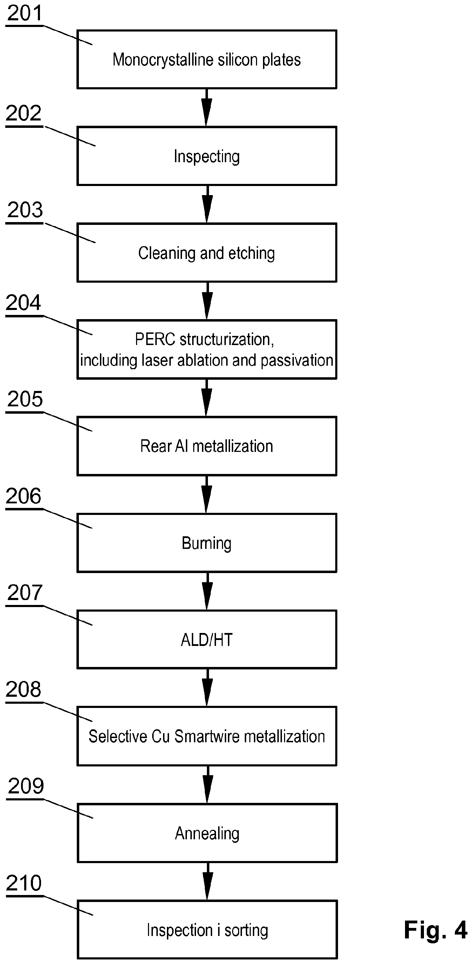

An architecture of the cell according to the present invention is presented in Fig. 2, and the method of its manufacturing is presented in Fig. 4. The basic steps and elements of the architecture are equivalent to the PERC architecture, which is known in the art, so they do not require detailed discussion. Hereinafter only the important differences to the conventional PERC architecture and technology will be discussed. Steps 201-203 are equivalent to conventional steps 101-103, as a result monocrystalline silicon plate 24 is obtained, prepared for further steps. In step 204 PERC structurization through laser ablation and passivation is carried out, to obtain passivating layer 23 AlOx and SiNx 23 on the back side of the substrate 24, equivalent to step 107. Subsequently in step 205 the back metallization is performed, thus obtaining a silver (Ag) and aluminum (Al) contact layer 22, equivalent to step 108. In step 206, burning is performed at the temperature range from 600 to 900 °C to obtain an electric contact to the base layer.

Subsequently, a tunnel layer 25 is manufactured. This layer can be a 1-2 nm thick silicon dioxide (SiO2) layer obtained thermally, by an ALD (Atomic Layer Deposition) method or a PECVD (Plasma-Enhanced Chemical Vapor Deposition) method. The tunnel layer can be also an Al₂O₃ layer, manufactured thermally or by using the ALD or PECVD method.

Subsequently in step 207 nanolayers 26 of the n-type or p-type doped zinc oxide are manufactured, which form together a single-junction structure. The layers 26 are manufactured in the process combining hydrothermal technology of ZnO nanorods production (e.g. as described in the patent applications WO2016182465 and PL400284) deposited with ZnO:Mg using the ALD (Atomic Layer Deposition) method. The nanorods layer 26 acts as an emitter, a UV filter and an antireflective layer. For that purpose, the support is at first deposited with nucleating layer 26A. For example, it can be a layer of gold, silver or nanoparticles of these metals, for example deposited by means of cathode sputtering. It can be also a ZnO layer or a nanoparticle ZnO layer deposited in at least one ALD cycle, wherein diethylzinc, dimethylzinc or zinc chloride can be used as zinc precursor, and water, ozone or oxygen plasma can be used as oxygen precursor. Upon depositing the nucleating layer 26A, the substrate is placed in a reaction mixture with pH of 6.5-12, containing a solvent, at least one oxygen precursor, and at least one zinc precursor, heated up to the temperature of 30-95°C and kept at this temperature for at least 1 second. The zinc concentration is preferably in the range of 0,001-1 M/dm³. For example, in the reaction mixture water can be used as oxygen precursor and zinc acetate as zinc precursor. The pH factor of the solution can be regulated with precipitation using metal hydroxide solution (e.g. NaOH, KOH). After this process, impurities are removed from the substrate and the active layer, for example by annealing them for at least 1 second, at the temperature of at least 100°C. Subsequently, thus obtained ZnO nanorods 26B with a height of 10-2000 nm are deposited with a ZnO:Mg layer 26C in an ALD process (preferably in at least 10 ALD cycles), wherein diethylzinc, dimethylzinc or zinc chloride can be used as zinc precursor and bis(cyclopentadienyl)magnesium or bis(methylcyclopentadienyl)magnesium can be used as magnesium precursor and water, ozone or oxygen plasma can be used as oxygen precursor. The thickness of the ZnO:Mg layer 26C can be 1-2000 nm. Subsequently, the emitter ZnO:NR/ZnO:Mg layer is deposited with a transparent ZnO:AI electrode layer 27 (preferably, in at least 100 ALD cycles). For that purpose, diethylzinc, dimethylzinc or zinc chloride can be used as zinc precursor, water, ozone or oxygen plasma can be used as oxygen precursor and trimethylaluminum can be used as aluminum precursor.

Subsequently in step 207 selective Al, Cu or Ag metallization or metallization is carried out, thus obtaining upper electric contacts 28 (fingers). In step 208 annealing is carried out at the temperature that does not exceed 350°C in order to obtain an electric ohmic contact to the emitter. The finished product is then inspected and stored in step 209.

### Example embodiment

A silicon monocrystalline plate with a electrical resistance of 2.3 Ωcm was prepared on the back side, according to the conventional PERC technology in steps 201-206, equivalent to steps 101, 102, 103, 107, 108, 109, as known from the conventional technology.

Subsequently, on the front side of the silicon plate 24, the SiO₂ tunnel layer 25 was obtained in such a manner, that a prepared substrate with a back metallization prepared in the PERC technology was introduced to the chamber of heating furnace with oxygen atmosphere, operating at the temperature up to 500 °C, and the tunnel layer 25 was obtained in a thermal process within the time of 15 minutes. Subsequently the active layer in the form of ZnO nanorods deposited with a thin ZnO:Mg layer was obtained on the tunnel layer 25. For that purpose, zinc oxide nuclei for hydrothermal growth of nanorods were deposited upon the upper surface of the tunnel layer 25 by the ALD method. Subsequently, the substrate with the nuclei was placed in the reaction mixture containing dissolved zinc acetate brought to the pH value of 8 by precipitation with 1M sodium hydroxide solution. The mixture and the substrate were heated up to the temperature of 50°C and the growth of nanorods to the height of 650 nm was continued in that temperature for 2 minutes . After the growth was complete, the substrate with the crystallized nanorods was rinsed in isopropanol to remove possible impurities, and deposition of ZnO:Mg layer upon them was initiated. For that purpose, the substrate was placed in an ALD reactor wherein it was annealed for 2 minutes in 200°C. After annealing, the reactor chamber was cooled down to 160°C, and in that temperature the ZnO nanorods were thoroughly deposited with ca. 200 nm thick ZnO layer in 1000 ALD cycles. The ZnO:Mg layer was deposited using diethylzinc as the zinc precursor, water as the oxygen precursor and bis(methylcyclopentadienyl)magnesium as the magnesium precursor. Subsequently, at the same temperature, without removing the substrate with the deposited active layer from the ALD reactor, the transparent electrode in the form of a 300 nm thick ZnO:AI layer was deposited. This layer was deposited using diethylzinc as the zinc precursor, water as the oxygen precursor and triethylaluminum as the aluminum precursor. Subsequently, aluminum (Al) contacts (fingers) were deposited on the ZnO:Al layer by a cathode sputtering process.

The photovoltaic cell according to the present invention, which is an alternative to conventional PERC cells, is distinguished by the presence of the tunnel layer as claimed in claim 1 between the silicon and ZnO layers and also by the presence of the multipurpose layer 26 acting as the antireflective, emitter and UV filter layer at the same time, which comprises undoped p-type or n-type conductive zinc oxide nanorods that together form a single-junction structure.

## Claims

1. A silicon photovoltaic cell, comprising a semiconductor p-type substrate, having at its rear side a PERC structure with an AlOx and SiNx passivating layer and back electric ohmic contacts, wherein on the front side of the silicon substrate (24) there is a tunnel layer (25), on which there is a layer of ZnO nanorods having a height of 10 to 2000 nm, that is deposited with a ZnO:Mg layer (26) having a thickness of 1 to 2000 nm, which is deposited with a ZnO:AI transparent conductive layer, upon which front electric ohmic contacts (28) are deposited, **characterized in that** the tunnel layer (25) is made of SiO₂ or Al₂O₃ obtained non-natively by the method selected from the group consisting of thermal method, Atomic layer Deposition (ADL) method and Plasma-Enhanced Chemical Vapor Deposition (PECVD) method.

2. A method of manufacturing a silicon photovoltaic cell according to claim 1, comprising subjecting a p-type substrate in a form of a monocrystalline silicon plate (Si) at its rear to a PERC structurization, depositing, at the front side the substrate (24), a tunnel layer (25), forming on the tunnel layer (25) a layer (26) of ZnO nanorods deposited with a ZnO:Mg layer, depositing the ZnO:Mg layer with a transparent ZnO:AI electrode (27), and forming upper electric ohmic contacts (28) on the transparent ZnO:AI electrode (27) **characterized by** deposing the tunnel layer (25) of SiO₂ or Al₂O₃ non-natively by the method selected from the group consisting of thermal method, Atomic layer Deposition (ADL) method and Plasma-Enhanced Chemical Vapor Deposition (PECVD) method.

3. The method according to claim 2, **characterized by** carrying out the growth of ZnO nanorods on one or more substrates simultaneously, up to 3000 substrates per batch.

## Patentansprüche

1. Silizium-Photovoltaikzelle, die ein p-Typ-Halbleitersubstrat umfasst, das an dessen Rückseite eine PERC-Struktur mit einer AlOx- und SiNx-Passivierungslage und hinteren elektrischen ohmschen Kontakten aufweist, wobei sich auf der Vorderseite des Siliziumsubstrats (24) eine Tunnellage (25) befindet, auf der sich eine Lage aus ZnO-Nanostäben mit einer Höhe von 10 bis 2000 nm befindet, die mit einer ZnO:Mg-Lage (26) mit einer Dicke von 1 bis 2000 nm abgeschieden wird, die mit einer ZnO:Al transparenten leitfähigen Lage abgeschieden wird, auf welcher vordere elektrische ohmsche Kontakte (28) abgeschieden werden, **dadurch gekennzeichnet, dass** die Tunnellage (25) aus SiO₂ oder Al₂O₃ besteht, die nicht nativ erhalten wird durch ein Verfahren, das ausgewählt ist aus der Gruppe bestehend aus einem thermischen Verfahren, einem Verfahren der Atomlagenabscheidung (ADL) und einem Verfahren der plasmaunterstützten chemischen Gasphasenabscheidung (PECVD).

2. Verfahren zur Herstellung einer Silizium-Photovoltaikzelle nach Anspruch 1, umfassend das Aussetzen eines p-Typ-Substrats in einer Form einer monokristallinen Siliziumplatte (Si) auf dessen Rückseite einer PERC-Strukturisierung, Abscheiden einer Tunnellage (25) auf der Vorderseite des Substrats (24), Ausbilden auf der Tunnellage (25) einer Lage (26) aus ZnO-Nanostäben, die mit einer ZnO:Mg-Lage abgeschieden wird, Abscheiden der ZnO:Mg-Lage mit einer transparenten ZnO:Al-Elektrode (27), und Ausbilden oberer elektrischer ohmscher Kontakte (28) auf der transparenten ZnO:Al-Elektrode (27), **gekennzeichnet durch** nicht natives Abscheiden der Tunnellage (25) aus SiO₂ oder Al₂O₃ durch das Verfahren, das ausgewählt ist aus der Gruppe bestehend aus einem thermischen Verfahren, einem Verfahren der Atomlagenabscheidung (ADL) und einem Verfahren der plasmaunterstützten chemischen Gasphasenabscheidung (PECVD).

3. Verfahren nach einem der Ansprüch 2, **gekennzeichnet durch** die Ausführung des Wachstums von ZnO-Nanostäben auf einem oder mehreren Substraten mit bis zu 3000 Substraten je Batch.

## Revendications

1. Cellule photovoltaïque en silicium, comprenant un substrat de type p semiconducteur, ayant au niveau de sa face arrière une structure PERC avec une couche de passivation en AlOx et SiNx et des contacts ohmiques électriques arrière, sur la face avant du substrat en silicium (24) se trouvant une couche tunnel (25), sur laquelle se trouve une couche de nanotiges de ZnO ayant une hauteur de 10 à 2 000 nm, qui est déposée avec une couche de ZnO:Mg (26) ayant une épaisseur de 1 à 2 000 nm, qui est déposée avec une couche conductrice transparente de ZnO:Al, sur laquelle sont déposés des contacts ohmiques électriques avant (28), **caractérisée en ce que** la couche tunnel (25) est constituée de SiO₂ ou de Al₂O₃ obtenu de manière non native par le procédé choisi dans le groupe constitué par un procédé thermique, un procédé de dépôt de couche atomique (ADL) et un procédé de dépôt chimique en phase vapeur activé par plasma (PECVD).

2. Procédé de fabrication d'une cellule photovoltaïque en silicium selon la revendication 1, comprenant les étapes consistant à soumettre un substrat de type p sous la forme d'une plaque de silicium monocristallin (Si) à l'arrière sur une structuration PERC, à déposer, au niveau de la face avant du substrat (24), une couche tunnel (25), à former sur la couche tunnel (25) une couche (26) de nanotiges de ZnO déposée avec une couche de ZnO:Mg, à déposer la couche de ZnO:Mg avec une électrode transparente de ZnO:AI (27), et à former des contacts ohmiques électriques supérieurs (28) sur l'électrode transparente de ZnO:AI (27), **caractérisé par** le dépôt de la couche tunnel (25) de SiO₂ ou de Al₂O₃ de manière non native par le procédé choisi dans le groupe constitué par un procédé thermique, un procédé de dépôt de couche atomique (ADL) et un procédé de dépôt chimique en phase vapeur activé par plasma (PECVD).

3. Procédé selon l'une quelconque des revendication 2, **caractérisé par** la réalisation de la croissance de nanotiges de ZnO sur au moins un substrat simultanément, jusqu'à 3 000 substrats par lot.
